(19) **Europäisches Patentamt / European Patent Office / Office européen des brevets**

(11) **EP 3 836 193 B1**

(12) **FASCICULE DE BREVET EUROPEEN**

(45) Date de publication et mention de la délivrance du brevet:
**09.03.2022 Bulletin 2022/10**

(21) Numéro de dépôt: **20206205.5**

(22) Date de dépôt: **06.11.2020**

(51) Classification Internationale des Brevets (IPC):
*H01L 21/265* (2006.01)   *H01L 33/32* (2010.01)
*H01L 33/34* (2010.01)   *H01L 33/40* (2010.01)
*H01L 29/20* (2006.01)

(52) Classification Coopérative des Brevets (CPC):
**H01L 21/2656; H01L 21/046; H01L 21/26553;**
H01L 29/2003; H01L 33/007; H01L 33/325;
H01L 2933/0016

(54) **PROCÉDÉ DE RÉALISATION D'UNE COUCHE SEMICONDUCTRICE DOPÉE**

VERFAHREN ZUR HERSTELLUNG EINER DOTIERTEN HALBLEITERSCHICHT

METHOD FOR MANUFACTURING A DOPED SEMICONDUCTOR LAYER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.12.2019 FR 1914289**

(43) Date de publication de la demande:
**16.06.2021 Bulletin 2021/24**

(73) Titulaire: **Commissariat à l'Energie Atomique et
aux Energies
Alternatives
75015 Paris (FR)**

(72) Inventeurs:
• **MAFFINI ALVARO, Virginie
38054 GRENOBLE CEDEX 9 (FR)**

• **BONO, Hubert
38054 GRENOBLE CEDEX 9 (FR)**
• **SIMON, Julia
38054 GRENOBLE CEDEX 9 (FR)**

(74) Mandataire: **Cabinet Beaumont
4, Place Robert Schuman
B.P. 1529
38025 Grenoble Cedex 1 (FR)**

(56) Documents cités:
JP-A- S6 047 428    JP-A- 2004 356 257
US-A- 4 391 651    US-A- 5 318 915
US-B1- 6 221 700

**Description**

<u>Domaine technique</u>

La présente description concerne un procédé d'obtention d'une couche semiconductrice dopée, notamment pour la réalisation de dispositifs électroluminescents.

<u>Technique antérieure</u>

Un dispositif électroluminescent comprend classiquement une ou plusieurs cellules électroluminescentes adaptées à convertir un signal électrique en un rayonnement lumineux. Chaque cellule électroluminescente peut comprendre un empilement d'une couche semiconductrice de type P, appelée couche d'anode, d'une couche active, et d'une couche semiconductrice dopée de type N, appelée couche de cathode. La couche semiconductrice d'anode est connectée électriquement à une électrode d'anode de la cellule, et la couche semiconductrice de cathode est connectée électriquement à une électrode de cathode de la cellule. En fonctionnement, un courant électrique est appliqué entre les couches semiconductrices d'anode et de cathode de la cellule, par l'intermédiaire des électrodes d'anode et de cathode. Sous l'effet de ce courant, la couche active émet un rayonnement lumineux dans une gamme de longueurs d'ondes qui dépend essentiellement de sa composition.

Pour limiter la résistance de contact entre l'électrode d'anode et la couche semiconductrice d'anode d'une part, et/ou entre l'électrode de cathode et la couche semiconductrice de cathode d'autre part, il est souhaitable de doper les couches semiconductrices d'anode et/ou de cathode à un niveau relativement élevé. Toutefois, selon le type de matériau semiconducteur utilisé pour former les couches d'anode et de cathode, ce dopage peut être difficile à réaliser. En particulier, il est difficile de doper à des niveaux élevés les matériaux semiconducteurs présentant une largeur de bande interdite élevée, et notamment les matériaux semiconducteurs de type III-V, par ailleurs bien adaptés à la réalisation de cellules électroluminescentes.

JP 2004 356257 A (TOYOTA CENTRAL RES & DEV) 16 décembre 2004 (2004-12-16) divulgue un procédé d'obtention d'une couche semiconductrice dopée.

Il serait souhaitable de pouvoir disposer d'un procédé d'obtention d'une couche semiconductrice dopée, ce procédé palliant tout ou partie des inconvénients des procédés de dopage connus.

<u>Résumé de l'invention</u>

Pour cela, un mode de réalisation prévoit un procédé d'obtention d'une couche semiconductrice dopée, comportant les étapes successives suivantes :

a) réaliser, dans une première couche monocristalline en un alliage semiconducteur d'au moins un premier élément A1 et un deuxième élément A2, une implantation ionique d'un premier élément B dopant pour ledit alliage et d'un deuxième élément C non dopant pour ledit alliage, de façon à rendre amorphe une partie supérieure de la première couche et à préserver la structure cristalline d'une partie inférieure de la première couche ; et

b) réaliser un recuit de recristallisation en phase solide de la partie supérieure de la première couche, conduisant à transformer la partie supérieure de la première couche en une couche monocristalline dopée dudit alliage,

dans lequel les éléments dopant B et non dopant C se substituent à des atomes de l'élément A1.

Selon un mode de réalisation, lors de l'étape a), une couche de protection recouvre la face supérieure de la première couche.

Selon un mode de réalisation, lors de l'étape a), les conditions d'implantation sont choisies de façon que la partie inférieure de la première couche présente une épaisseur inférieure au cinquième de l'épaisseur de la première couche.

Selon un mode de réalisation, lors de l'étape a), les conditions d'implantation sont choisies de façon que la partie inférieure de la première couche présente une épaisseur comprise entre 2 et 10 nm.

Selon un mode de réalisation, lors de l'étape a), une implantation complémentaire de l'élément A2 est réalisée pour compenser l'apport des éléments B et C.

Selon un mode de réalisation, l'élément non dopant C est choisi en tenant compte du rapport entre le rayon de covalence de l'élément A1 et le rayon de covalence de l'élément dopant B, de façon à obtenir, à l'issue de l'étape b), une maille globalement non contrainte.

Selon un mode de réalisation, lorsque le rayon de covalence de l'élément dopant B est supérieur au rayon de covalence de l'élément A1, l'élément non dopant C est choisi pour présenter un rayon de covalence inférieur ou égal à celui de l'élément A1, et, lorsque le rayon de covalence de l'élément dopant B est inférieur au rayon de covalence de l'élément A1, l'élément non dopant C est choisi pour présenter un rayon de covalence supérieur ou égal à celui de l'élément A1.

Selon un mode de réalisation, les éléments A1 et A2 sont respectivement un élément du groupe III et un élément du groupe V, et l'élément B est un élément du groupe II ou un élément du groupe IV, et l'élément C est un élément du groupe III.

Selon un mode de réalisation, les éléments A1 et A2 sont respectivement le gallium et l'azote.

Selon un mode de réalisation, les éléments B et C sont respectivement le magnésium et l'aluminium.

Selon un mode de réalisation, les éléments B et C sont respectivement le silicium et l'indium.

Selon un mode de réalisation, les éléments A1 et A2 sont respectivement le silicium et le carbone, et les éléments B et C sont respectivement le bore ou le germanium, ou les éléments B et C sont respectivement l'arsenic et le carbone.

Selon un mode de réalisation, à l'étape b), le recuit de recristallisation en phase solide est effectué à une température comprise entre 300 et 1200°C.

Selon un mode de réalisation, le recuit de recristallisation en phase solide est effectué à environ 400°C.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

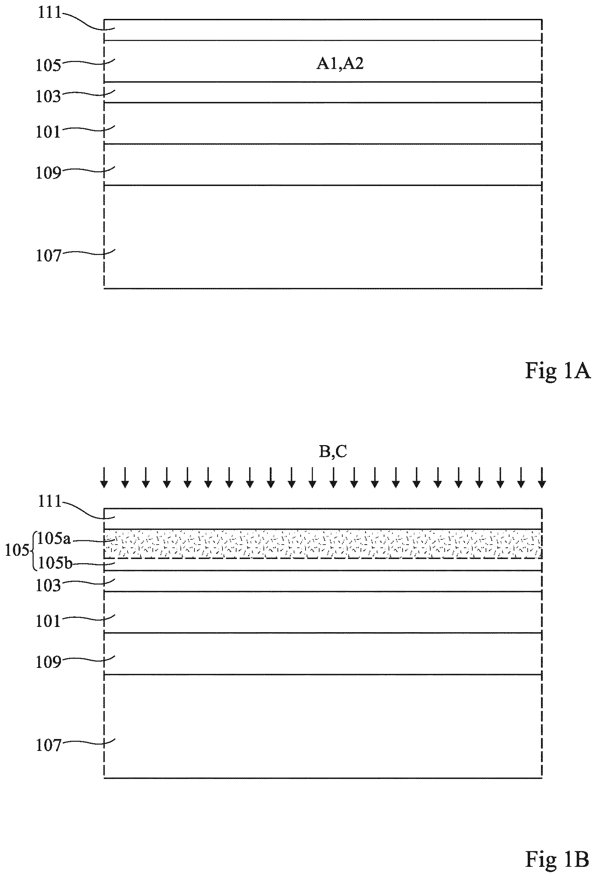

la figure 1A représente de façon schématique une étape d'un procédé d'obtention d'une couche semiconductrice dopée selon un mode de réalisation ;

la figure 1B représente de façon schématique une autre étape d'un procédé d'obtention d'une couche semiconductrice dopée selon un mode de réalisation ; et

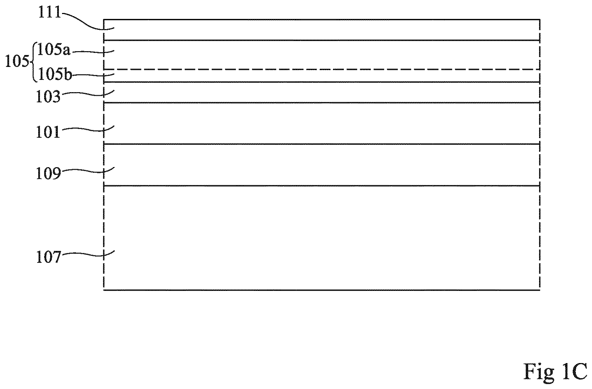

la figure 1C représente de façon schématique une autre étape d'un procédé d'obtention d'une couche semiconductrice dopée selon un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la description qui suit concerne principalement l'obtention d'une couche semiconductrice dopée. Les différentes structures dans lesquelles une telle couche peut être utilisée n'ont pas été détaillée. De plus, les étapes pouvant être mises en oeuvre, avant ou après la réalisation de la couche dopée, pour obtenir de telles structures, n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les figures 1A à 1C sont des vues en coupe illustrant des étapes successives d'un exemple d'un procédé d'obtention d'une couche semiconductrice dopée selon un mode de réalisation.

On considère dans cet exemple la réalisation d'un empilement de cellule électroluminescente comportant une première couche semiconductrice 101 d'un premier type de conductivité formant une couche d'anode ou de cathode de la cellule, d'une couche active 103, et d'une deuxième couche semiconductrice 105 dopée du second type de conductivité formant une couche de cathode ou d'anode de la cellule. Les couches 101 et 105 sont par exemple des couches d'un matériau semiconducteur III-V, par exemple des couches de nitrure de gallium. La couche active 103 comprend par exemple des moyens de confinement correspondant à des puits quantiques multiples. A titre d'exemple, la couche active 103 est constituée d'une alternance de couches semiconductrices d'un premier matériau et de couches semiconductrices d'un deuxième matériau, chaque couche du premier matériau étant prise en sandwich entre deux couches du deuxième matériau, le premier matériau ayant une bande interdite plus étroite que celle du deuxième matériau, de façon à définir des puits quantiques multiples. Les couches 101, 103 et 105 sont par exemple formées par épitaxie. L'empilement des couches 101, 103 et 105 est disposé sur un substrat de support 107, par exemple en saphir ou en silicium. Un empilement 109 d'une ou plusieurs couches tampon peut faire interface entre le substrat 107 et l'empilement des couches 101, 103 et 105. Dans l'exemple représenté, l'empilement 109 est disposé sur et en contact avec la face supérieure du substrat 107, la couche 101 est disposée sur et en contact avec la face supérieure de l'empilement 109, la couche 103 est disposée sur et en contact avec la face supérieure de la couche 101, et la couche 105 est disposée sur et en contact avec la face supérieure de la couche 103.

On s'intéresse ici plus particulièrement au dopage de la couche semiconductrice supérieure 105 de l'empilement.

La figure 1A illustre la structure obtenue à l'issue d'une étape de dépôt d'une couche isolante de protection 111, par exemple en nitrure de silicium ($Si_3N_4$), du côté de la face supérieure de la couche 105, par exemple en contact avec la face supérieure de la couche 105. La couche 111 s'étend par exemple sur toute la surface de la couche 105. L'épaisseur de la couche 111 est par exemple comprise entre 5 et 500 nm, et de préférence entre 10 et 50 nm, par exemple de l'ordre de 20 nm. A ce stade, la couche 105 peut être une couche non dopée. A titre de variante, la couche 105 peut avoir déjà été préalablement dopée in-situ lors de sa croissance épitaxiale. On cherche dans ce cas à augmenter le niveau de dopage de la couche 105.

La figure 1B illustre une étape d'implantation ionique, dans la couche semiconductrice 105, à travers la couche de protection 111, d'un élément dopant pour le matériau de la couche 105. Lors de cette étape, comme cela sera expliqué plus en détail ci-après, un élément non dopant pour le matériau de la couche 105 est en outre implanté, de préférence sans étape intermédiaire de recuit de façon à limiter, à l'échelle de la maille, les contraintes introduites par l'élément dopant.

Les énergies et doses d'implantation de l'élément dopant et de l'élément non dopant sont choisies en fonction du profil de dopage souhaité. Les énergies et doses d'implantation sont de plus choisies de façon à obtenir une amorphisation complète d'une partie supérieure 105a de la couche 105, et à conserver la référence cristalline d'origine dans une partie inférieure 105b de la couche 105. De préférence, l'épaisseur de la couche monocristalline inférieure de référence 105b est relativement faible pour permettre l'évacuation d'éventuelles dislocations ou autres défauts cristallins lors d'une étape ultérieure de recuit de recristallisation de la couche 105a. A titre d'exemple, l'épaisseur de la couche monocristalline inférieure de référence 105b est inférieure à la moitié de l'épaisseur de la couche 105 d'origine, par exemple inférieure à un cinquième de l'épaisseur de la couche 105 d'origine. A titre d'exemple, l'épaisseur de la couche monocristalline inférieure de référence 105b est comprise entre 2 et 100 nm, de préférence entre 2 et 10 nm. La couche 105 a par exemple une épaisseur comprise entre 10 et 500 nm, par exemple entre 100 et 400 nm.

La couche de protection 111 permet notamment de protéger la couche 105 contre la pulvérisation lors de l'étape d'implantation ionique de l'élément dopant et de l'élément non dopant.

La figure 1C illustre une étape de recuit de la structure obtenue à l'issue des étapes des figures 1A et 1B, de façon à obtenir une recristallisation en phase solide de la partie supérieure 105a de la couche 105. Le recuit est par exemple réalisé à une température comprise entre 300 et 1200°C. La durée du recuit de recristallisation est par exemple comprise entre 1 minute et 10 heures. De préférence, le recuit est réalisé à basse température, par exemple à environ 400°C, par exemple pendant environ 1 heure. Lors de cette étape, on obtient une recristallisation de la couche 105a. La référence cristalline est donnée par la couche monocristalline 105b sous-jacente. A l'issue de cette étape, on obtient une couche semiconductrice cristalline 105a dopée. Le niveau de dopage de la couche 105a dépend de la dose de l'élément dopant implantée à l'étape de la figure 1B.

La couche de protection 111 peut être retirée après le recuit. A titre de variante, la couche 111 peut être retirée avant le recuit. Des étapes ultérieures, non détaillées, peuvent ensuite être mises en oeuvre pour réaliser une ou plusieurs cellules électroluminescentes à partir de la structure obtenue. En particulier, une étape de dépôt d'une électrode sur et en contact avec la couche 105a peut être prévue.

Le procédé de dopage décrit en relation avec les figures 1A à 1C est particulièrement avantageux pour le dopage d'une couche d'un matériau semiconducteur de type III-V. Ce procédé peut toutefois être adapté au dopage d'autres alliages semiconducteurs, et en particulier des alliages semiconducteurs présentant une largeur de bande interdite élevée, par exemple supérieure à 1,5 eV et de préférence supérieure à 3 eV.

De façon générale, la couche 105 peut être une couche monocristalline d'un alliage d'au moins un premier élément que l'on appellera ci-après élément A1, par exemple du groupe III et un deuxième élément que l'on appellera ci-après élément A2, par exemple du groupe V. L'élément dopant implanté à l'étape de la figure 1B, que l'on appellera ci-après élément B, peut être un élément dopant de type P ou de type N. A titre d'exemple, l'élément dopant B est destiné à se substituer à des atomes de l'élément A1 de l'alliage initial pour obtenir un dopage de type P ou un dopage de type N. Dans le cas où l'élément A1 de l'alliage est un élément du groupe III, l'élément dopant B peut être un élément du groupe II pour obtenir un dopage de type P, ou un élément du groupe IV pour obtenir un dopage de type N. Le rayon de covalence de l'élément dopant B peut être différent de celui de l'élément substitué A1. L'élément non dopant implanté à l'étape de la figure 1B, que l'on appellera ci-après élément C, est choisi de façon à compenser les contraintes introduites, à l'échelle de la maille, par l'élément dopant B. A titre d'exemple, si l'élément dopant B présente un rayon de covalence inférieur à celui de l'élément substitué A1, on pourra choisir comme élément non dopant C un élément du même groupe que l'élément A1 présentant un rayon de covalence supérieur ou égal et de préférence strictement supérieur à celui de l'élément A1. A l'inverse, si l'élément dopant B présente un rayon de covalence supérieur à celui de l'élément substitué A1, on pourra choisir comme élément non dopant C un élément du même groupe que l'élément A1 présentant un rayon de covalence inférieur ou égal et de préférence strictement inférieur à celui de l'élément A1.

Lors de l'étape d'implantation de la figure 1B, outre les éléments B et C, on pourra implanter des atomes de l'élément A2 de l'alliage initial, de préférence sans étape intermédiaire de recuit, de façon à compenser l'apport des éléments B et C et conserver la stoechiométrie globale du matériau.

La dose d'implantation de l'élément dopant B lors de l'étape de la figure 1B est de préférence relativement élevée, par exemple supérieure à $10^{20}$ atomes/cm$^3$, de façon à favoriser l'amorphisation de la partie supérieure 105a de la couche 105.

Des exemples d'application du procédé des figures 1A à 1C au dopage d'une couche de nitrure de gallium (GaN) vont maintenant être décrits. Dans ce cas, la couche semiconductrice initiale 105 est une couche de GaN monocristallin. Les éléments A1 et A2 de l'alliage semiconducteur formant la couche 105 initiale sont respectivement le gallium (Ga) et l'azote (N). La couche 105a que l'on cherche à obtenir à l'issue du procédé est une couche de $C_yB_xGa_{1-x-y}N$, x et y définissant respectivement la concentration de l'élément dopant B et la concentration de l'élément non dopant C dans la couche finale. L'élément dopant B doit se substituer au gallium (Ga). La concentration x de l'élément dopant B est choisie de façon à obtenir le niveau de dopage souhaité. L'élément non dopant C et la concentration y de l'élément non dopant C sont choisis en fonction du rayon de covalence de l'élément dopant B et de la concentration x de l'élément dopant B de façon à obtenir in fine une couche 105a globalement non contrainte.

A titre d'exemple, les concentrations x et y sont choisies de façon à respecter la règle de mélange suivante :

[Math 1]

$$a * x + b * y = 0$$

Avec :

[Math 2]

$$a = \frac{1}{3} * \left(1 - \frac{RB}{Rh}\right)^3 * \frac{1}{S}$$

Et:

[Math 3]

$$b = \frac{1}{3} * \left(1 - \frac{RC}{Rh}\right)^3 * \frac{1}{S}$$

Où RB, RC et Rh désignent respectivement les rayons de covalence des éléments B, C et A1 (Ga dans cet exemple), et S désigne la concentration de sites dans la matrice hôte, c'est-à-dire le nombre d'atomes de gallium dans la maille de la couche 105 initiale.

Plus généralement, pour définir la concentration y de l'élément non dopant C, d'autres règles de mélange peuvent être définies, à partir d'une modélisation des contraintes dans un alliage semiconducteur cristallin.

Lors de l'étape d'implantation de la figure 1C, outre les éléments B et C, on prévoit d'implanter de l'azote (élément A2), de préférence sans étape intermédiaire de recuit, de façon à compenser l'apport des éléments B et C et à conserver la stoechiométrie globale du matériau. En l'absence de cette co-implantation d'azote, la stoechiométrie de la couche 105a finale serait $C_yB_xGa_{1-x-y}N_{1-x-y}$. Pour compenser l'implantation des éléments B et C, on prévoit ici une co-implantation d'azote à une concentration z=x+y.

## Cas du dopage P :

Pour obtenir une couche 105a dopée de type P, l'élément dopant B implanté à l'étape de la figure 1B peut être un élément du groupe II, par exemple le magnésium (Mg), le béryllium (Be), le Zinc (Zn) ou le calcium (Ca). L'élément non dopant C peut quant à lui être un élément du même groupe que le gallium, c'est-à-dire un élément du groupe III, par exemple de l'aluminium ou de l'indium. De préférence, l'élément dopant B est le magnésium. Dans le cas où l'élément dopant B est le magnésium, l'élément non dopant C est de préférence l'aluminium. En effet, le magnésium présente un rayon de covalence plus grand que celui du gallium, tandis que l'aluminium présente un rayon de covalence plus petit que celui du gallium, ce qui permet d'équilibrer les contraintes dans la maille.

A titre d'exemple, la dose de magnésium implantée est de l'ordre de $3*10^{15}$ atomes/cm$^2$ avec une énergie d'implantation de l'ordre de 23 keV, la dose d'aluminium implantée est de l'ordre de $4,6*10^{15}$ atomes/cm$^2$ avec une énergie d'implantation de l'ordre de 120 keV, et la dose d'azote implantée est de l'ordre de $9,6*10^{15}$ atomes/cm$^2$ avec une énergie d'implantation de l'ordre de 15 keV.

Cas du dopage N :

Pour obtenir une couche 105a dopée de type N, l'élément dopant B implanté à l'étape de la figure 1B peut être un élément du groupe IV, par exemple le silicium (Si), le germanium (Ge) ou le carbone (C). L'élément non dopant C peut quant à lui être un élément du même groupe que le gallium, c'est-à-dire un élément du groupe III, par exemple de l'aluminium ou de l'indium. De préférence, l'élément dopant B est le silicium. Dans le cas où l'élément dopant B est le silicium, l'élément non dopant C est de préférence l'indium. En effet, le silicium présente un rayon de covalence plus petit que celui du gallium, tandis que l'indium présente un rayon de covalence plus grand que celui du gallium, ce qui permet d'équilibrer les contraintes dans la maille.

La personne du métier saura adapter le procédé décrit ci-dessus au dopage d'autres alliages semiconducteurs. Par exemple, dans le cas où la couche 105 est en carbure de silicium (SiC), les éléments A1 et A2 sont respectivement le silicium (Si) et le carbone (C). Pour obtenir un dopage de type P, l'élément dopant B peut être un élément du groupe II, par exemple le bore (B), et l'élément non dopant C peut être un élément du groupe III, par exemple le germanium. Pour obtenir un dopage de type N, l'élément dopant B peut être un élément du groupe IV, par exemple de l'arsenic, et l'élément non dopant C peut être un élément du groupe III, par exemple le carbone.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux ni aux exemples de valeurs numériques mentionnés dans la description.

De plus, bien que l'on ait décrit ci-dessus un exemple d'application du procédé de dopage à la réalisation de cellules électroluminescentes, les modes de réalisation décrits ne se limitent pas à cette application particulière. A titre de variante, le procédé d'obtention d'une couche semiconductrice dopée décrit ci-dessus peut être utilisé pour d'autres applications, par exemple pour la réalisation de composants semiconducteurs de puissance (transistors, diodes, etc.).

**Revendications**

1. Procédé d'obtention d'une couche semiconductrice dopée, comportant les étapes successives suivantes :

   a) réaliser, dans une première couche (105) monocristalline en un alliage semiconducteur d'au moins un premier élément A1 et un deuxième élément A2, une implantation ionique d'un premier élément B dopant pour ledit alliage et d'un deuxième élément C non dopant pour ledit alliage, de façon à rendre amorphe une partie supérieure (105a) de la première couche (105) et à préserver la structure cristalline d'une partie inférieure (105b) de la première couche (105) ; et
   b) réaliser un recuit de recristallisation en phase solide de la partie supérieure (105a) de la première couche (105), conduisant à transformer la partie supérieure (105a) de la première couche (105) en une couche monocristalline dopée dudit alliage,

   dans lequel les éléments dopant B et non dopant C se substituent à des atomes de l'élément A1.

2. Procédé selon la revendication 1, dans lequel, lors de l'étape a), une couche de protection (111) recouvre la face supérieure de la première couche (105).

3. Procédé selon la revendication 1 ou 2, dans lequel, lors de l'étape a), les conditions d'implantation sont choisies de façon que la partie inférieure (105b) de la première couche (105) présente une épaisseur inférieure au cinquième de l'épaisseur de la première couche (105).

4. Procédé selon l'une quelconque des revendications 1 à 3, dans lequel, lors de l'étape a), les conditions d'implantation sont choisies de façon que la partie inférieure (105b) de la première couche (105) présente une épaisseur comprise entre 2 et 10 nm.

5. Procédé selon l'une quelconque des revendications 1 à 4, dans lequel, lors de l'étape a), une implantation complémentaire de l'élément A2 est réalisée pour compenser l'apport des éléments B et C.

6. Procédé selon l'une quelconque des revendications 1 à 5, dans lequel l'élément non dopant C est choisi en tenant compte du rapport entre le rayon de covalence de l'élément A1 et le rayon de covalence de l'élément dopant B, de façon à obtenir, à l'issue de l'étape b), une maille globalement non contrainte.

7. Procédé selon l'une quelconque des revendications 1 à 6, dans lequel, lorsque le rayon de covalence de l'élément dopant B est supérieur au rayon de covalence de l'élément A1, l'élément non dopant C est choisi pour présenter un rayon de covalence inférieur ou égal à celui de l'élément A1, et, lorsque le rayon de covalence de l'élément dopant B est inférieur au rayon de covalence de l'élément A1, l'élément non dopant C est choisi pour présenter un rayon de covalence supérieur ou égal à celui de l'élément A1.

8. Procédé selon l'une quelconque des revendications 1 à 7, dans lequel les éléments A1 et A2 sont respectivement un élément du groupe III et un élément du groupe V, et dans lequel l'élément B est un élément du groupe II ou un élément du groupe IV, et l'élément C est un élément du groupe III.

9. Procédé selon la revendication 8, dans lequel les éléments A1 et A2 sont respectivement le gallium et l'azote.

10. Procédé selon la revendication 9, dans lequel les éléments B et C sont respectivement le magnésium et l'aluminium.

11. Procédé selon la revendication 9, dans lequel les éléments B et C sont respectivement le silicium et l'indium.

12. Procédé selon l'une quelconque des revendications 1 à 7, dans lequel les éléments A1 et A2 sont respectivement le silicium et le carbone, et dans lequel les éléments B et C sont respectivement le bore ou le germanium, ou dans lequel les éléments B et C sont respectivement l'arsenic et le carbone.

13. Procédé selon l'une quelconque des revendications 1 à 12, dans lequel, à l'étape b), le recuit de recristallisation en phase solide est effectué à une température comprise entre 300 et 1200°C.

14. Procédé selon l'une quelconque des revendications 1 à 13, dans lequel le recuit de recristallisation en phase solide est effectué à environ 400°C.

**Patentansprüche**

1. Ein Verfahren zur Herstellung einer dotierten Halbleiterschicht, das die folgenden aufeinanderfolgenden Schritte aufweist:

a) Durchführen, in einer ersten einkristallinen Schicht (105) aus einer Halbleiterlegierung aus mindestens einem ersten Element A1 und einem zweiten Element A2, einer Ionenimplantation eines ersten Elements B, das ein dotierendes Element für die Legierung ist, und eines zweiten Elements C, das kein dotierendes Element für die Legierung ist, um einen oberen Teil (105a) der ersten Schicht (105) amorph zu machen und die Kristallstruktur eines unteren Teils (105b) der ersten Schicht (105) zu erhalten; und
b) Durchführen eines Festphasen-Rekristallisationsglühens des oberen Teils (105a) der ersten Schicht (105), was zu einer Umwandlung des oberen Teils (105a) der ersten Schicht (105) zu einer dotierten einkristallinen Schicht der Legierung führt,

wobei die dotierenden und nichtdotierenden Elemente B und C Atome des Elements A1 ersetzen.

2. Verfahren nach Anspruch 1, wobei während des Schritts a) eine Schutzschicht (111) die obere Oberfläche der ersten Schicht (105) bedeckt.

3. Verfahren nach Anspruch 1, wobei während des Schritts a) die Implantationsbedingungen so gewählt werden, dass der untere Teil (105b) der ersten Schicht (105) eine Dicke von weniger als einem Fünftel der Dicke der ersten Schicht (105) aufweist.

**4.** Verfahren nach Anspruch 1, wobei während des Schritts a) die Implantationsbedingungen so gewählt werden, dass der untere Abschnitt (105b) der ersten Schicht (105) eine Dicke im Bereich von 2 bis 10 nm aufweist.

**5.** Verfahren nach Anspruch 1, wobei während des Schritts a) eine komplementäre Implantation des Elements A2 durchgeführt wird, um die Zugabe der Elemente B und C zu kompensieren.

**6.** Verfahren nach Anspruch 1, wobei das nichtdotierende Element C unter Berücksichtigung des Verhältnisses des kovalenten Radius von Element A1 zum kovalenten Radius des dotierenden Elements B ausgewählt wird, um am Ende von Schritt b) eine im Allgemeinen nicht gespannte Zelle zu erhalten.

**7.** Verfahren nach Anspruch 1, wobei, wenn der kovalente Radius des dotierenden Elements B größer ist als der kovalente Radius von Element A1, das nichtdotierende Element C so ausgewählt wird, dass es einen kovalenten Radius aufweist, der kleiner oder gleich dem von Element A1 ist, und, wenn der kovalente Radius des dotierenden Elements B kleiner ist als der kovalente Radius von Element A1, das nichtdotierende Element C so ausgewählt wird, dass es einen kovalenten Radius aufweist, der größer oder gleich dem von Element A1 ist.

**8.** Verfahren nach Anspruch 1, wobei die Elemente A1 und A2 ein Gruppe-III-Element bzw. ein Gruppe-V-Element sind, und wobei Element B ein Gruppe-II-Element oder ein Gruppe-IV-Element ist und Element C ein Gruppe-III-Element ist.

**9.** Verfahren nach Anspruch 8, wobei die Elemente A1 und A2 Gallium bzw. Stickstoff sind.

**10.** Verfahren nach Anspruch 9, wobei die Elemente B und C Magnesium bzw. Aluminium sind.

**11.** Verfahren nach Anspruch 9, wobei es sich bei den Elementen B und C um Silizium bzw. Indium handelt.

**12.** Verfahren nach Anspruch 1, wobei die Elemente A1 und A2 Silizium bzw. Kohlenstoff sind, und wobei die Elemente B und C Bor bzw. Germanium sind, oder wobei die Elemente B und C Arsen bzw. Kohlenstoff sind.

**13.** Verfahren nach Anspruch 1, wobei in Schritt b) das Festphasen-Rekristallisationsglühen bei einer Temperatur im Bereich von 300 bis 1.200°C durchgeführt wird.

**14.** Verfahren nach Anspruch 1, wobei das Festphasenkristallisationsglühen bei etwa 400°C durchgeführt wird.

**Claims**

**1.** A method of obtaining a doped semiconductor layer, comprising the successive steps of:

a) performing, in a first single-crystal layer (105) made of a semiconductor alloy of at least a first element A1 and a second element A2, an ion implantation of a first element B which is a dopant for said alloy and of a second element C which is not a dopant for said alloy, to make an upper portion (105a) of the first layer (105) amorphous and to preserve the crystal structure of a lower portion (105b) of the first layer (105); and
b) performing a solid phase recrystallization anneal of the upper portion (105a) of the first layer (105), resulting in transforming the upper portion (105a) of the first layer (105) into a doped single-crystal layer of said alloy,

wherein the dopant and non-dopant elements B and C substitute to atoms of element A1.

**2.** The method according to claim 1, wherein, during step a), a protection layer (111) covers the upper surface of the first layer (105).

**3.** The method according to claim 1, wherein, during step a), the implantation conditions are selected so that the lower portion (105b) of the first layer (105) has a thickness smaller than one fifth of the thickness of the first layer (105).

**4.** The method according to claim 1, wherein, during step a), the implantation conditions are selected so that the lower portion (105b) of the first layer (105) has a thickness in the range from 2 to 10 nm.

5. The method according to claim 1, wherein, during step a), a complementary implantation of element A2 is performed to compensate for the addition of elements B and C.

6. The method according to claim 1, wherein non-dopant element C is selected while taking into account the ratio of the covalent radius of element A1 to the covalent radius of dopant element B, to obtain, at the end of step b), a generally non-stressed cell.

7. The method according to claim 1, wherein, when the covalent radius of dopant element B is greater than the covalent radius of element A1, non-dopant element C is selected to have a covalent radius smaller than or equal to that of element A1, and, when the covalent radius of dopant element B is smaller than the covalent radius of element A1, non-dopant element C is selected to have a covalent radius greater than or equal to that of element A1.

8. The method according to claim 1, wherein elements A1 and A2 are respectively a group-III element and a group-V element, and wherein element B is a group-II element or a group-IV element, and element C is a group-III element.

9. The method according to claim 8, wherein elements A1 and A2 respectively are gallium and nitrogen.

10. The method according to claim 9, wherein elements B and C respectively are magnesium and aluminum.

11. The method according to claim 9, wherein elements B and C respectively are silicon and indium.

12. The method according to claim 1, wherein elements A1 and A2 are respectively silicon and carbon, and wherein elements B and C respectively are boron or germanium, or wherein elements B and C respectively are arsenic and carbon.

13. The method of claim 1, wherein, at step b), the solid phase recrystallization anneal is carried out at a temperature in the range from 300 to 1,200°C.

14. The method according to claim 1, wherein the solid phase crystallization anneal is carried out at approximately 400°C.

111

105 — A1,A2

103

101

109

107

**Fig 1A**

B,C

↓↓↓↓↓↓↓↓↓↓↓↓↓↓↓↓↓↓↓↓↓↓↓

111

105 { 105a

105b

103

101

109

107

**Fig 1B**

111

105 { 105a
105b

103

101

109

107

Fig 1C

**EP 3 836 193 B1**

## RÉFÉRENCES CITÉES DANS LA DESCRIPTION

**Documents brevets cités dans la description**

- JP 2004356257 A